Europäisches Patentamt

European Patent Office

Office européen des brevets

(19)

(11) EP 0 788 170 A2

(12) **EUROPEAN PATENT APPLICATION**

(43) Date of publication:
06.08.1997 Bulletin 1997/32

(51) Int Cl.⁶: **H01L 29/768**, H01L 27/148

(21) Application number: 97200212.5

(22) Date of filing: 27.01.1997

(84) Designated Contracting States:
**DE FR GB**

(30) Priority: 05.02.1996 US 595458

(71) Applicant: **EASTMAN KODAK COMPANY**
**(a New Jersey corporation)**
**Rochester, New York 14650 (US)**

(72) Inventor: **Stevens, Eric G.,**
**Eastman Kodak Company**
**Rochester, New York 14650-2201 (US)**

(74) Representative: **Parent, Yves et al**
**KODAK INDUSTRIE**
**Département Brevets - CRT**
**Zone Industrielle**
**B.P. 21**
**71102 Chalon-sur-Saône Cédex (FR)**

(54) **Source-follower amplifier employing a fully depleted well structure**

(57)    Transistor fabrication upon a semiconductor substrate of a first conductivity type is discussed, having a well of a second conductivity type opposite the first conductivity type formed in the substrate. Transistors are fabricated within the well, such that the transistor has a source, and a drain with a channel between the source and the drain, and further having a gate electrode structure situated between the source and the drain and above the channel. A source follower configuration having a driver transistor and a load transistor is discussed. The source, and drain are of first conductivity type, and a portion of the well extending at least beneath the source and the drain of the driver transistor has a doping level in a range such that allows the well to become fully depleted.

FIG. 2

EP 0 788 170 A2

## Description

### Field of Invention

The invention relates generally to the field of transistors fabricated upon semiconductor substrates, and more specifically, to transistor structures that improve the linearity of circuits using these transistors.

### Background Of The Invention

The use of a common-drain, or source-follower configuration as an on chip-buffer amplifier for conventional floating-diffusion amplifiers typically used as electrometers on solid-state image sensors is well known. It is also well known that the linearity of the typical source follower configuration is strongly affected by the so-called body effect of the FETs used in making up this circuit configuration. This was expressed in the prior art by Paul R. Gray and Robert G. Meyer, in the Analysis and Design Of Analog Integrated Circuits, 2nd Ed., Wiley, 1984.

It is well known that the higher the background doping concentration is of the drive FETs, the higher the body effect, and hence, the lower the gain, and the more nonlinear this circuit becomes. This was, again, expressed by P. Gray and R. Meyer in Analysis and Design Of Analog Integrated Circuits, 2nd Ed., Wiley, 1984. One prior art attempt to get around this problem that has been reported in the past, is to eliminate the body effect by tying the source of the drive transistor directly to the body of the device. This well-known technique used in standard CMOS technology has been extended to an interline image sensor process wherein a p-well is formed in the n-type substrate for use as a VOD antiblooming structure. In this process, the drive transistors can be placed in isolated p-wells, and hence, their source and body nodes can be tied together. This would not be possible for sensors built in a p-type substrate without wells since this would result in shorting the output nodes of the source followers to ground. There is a limitation using this approach, however, in that to insure the output is not clamped, or clipped, as a result of the body of the FET becoming forward biasing with the substrate, the reset drain voltage should be kept lower (as a rule of thumb) than the n-type substrate voltage. Therefore, since recently it has been desired to reduce the substrate voltage to allow lower voltage electronic shuttering, this technique becomes difficult to implement.

It should be apparent from the foregoing discussion, that there remains a need within the art for a transistor design upon a semiconductor substrate that yields high gain and increased linearity.

### Summary Of The Invention

The present invention is directed to overcoming one or more of the problems set forth above.

By reducing the background concentration a reduction in body effect is achieved. However, care must be taken not to reduce the background concentration too much, or a so-called punchthrough condition will exist which will result in poor amplifier performance. Punchthrough, in this case, is when the potential barrier between the substrate and the transistor's source and drain nodes become small enough that current flow will exist between the source and drain nodes and the substrate. Therefore, as a rule of thumb, the background concentration is kept just high enough so that it is not fully depleted to ensure an adequate barrier is maintained so that punchthrough won't occur. Heretofore, it has not been realized that a high-performance source-follower circuit can be built by reducing the well concentration to a level at which it becomes fully depleted. To the inventor's knowledge, it has not been appreciated that there is an optimum doping level range wherein the p-well is fully depleted, thereby eliminating body effect and improving the amplifier's performance, while still providing a sufficient barrier to the substrate to prevent punchthrough.

Briefly summarized, this invention discloses a method of fabricating a transistor and a transistor apparatus that is used in the output amplifier of a typical CCD image sensor employing a well process (for antiblooming) so as to greatly increase the amplifier's linear operating range. This is done by lightly doping the well under the drive transistors used in the typical source-follower circuit configuration of the floating diffusion amplifier so that it is completely depleted, thereby eliminating body effect, yet not so light so as to eliminate the barrier between the source and drain nodes of these transistors and the substrate.

In accordance with one aspect, the present invention envisioned is an output amplifier comprising: a semiconductor substrate of a first conductivity type having formed thereon a well of a second conductivity type that is opposite the first conductivity type; a source follower circuit having a driver transistor and a load transistor formed within the well, each of the driver transistor and the load transistor having a source node and a drain node formed of the first conductivity type; a channel region between the source node and drain node for the driver transistor and the load transistor; a gate electrode on top of the channel region and between the source node and the drain node for each of the driver transistor and the load transistor; and an area within the well beneath the driver transistor that is more lightly doped of the second conductivity type than surrounding areas of the well.

Body effect of an MOSFET transistor results in a change in threshold voltage, $V_t$, with so-called back-gate bias,

$V_{sb}$, (i.e., the voltage between the source node and the body of the device). The $V_t$ of an MOSFET is given by the well known equation:

$$\text{Equation 1} \qquad v_t = v_{to} + \gamma[\sqrt{V_{sb} + 2\varnothing_F} - \sqrt{2\varnothing_F}]$$

where:

$V_t$    is the threshold voltage;
$V_{to}$    is the zero back bias threshold voltage (with $V_{sb}=0$) ;
$\gamma$    is the threshold voltage parameter that relates the change in threshold voltage to the back bias;
$V_{sb}$    is the source to body bias (back bias);
$\varnothing_F$    is the so called Fermi potential which is related to the surface potential in strong inversion.

Since the current of these transistors in saturation can be approximated by the well known square law illustrated in Equation 2.

$$\text{Equation 2} \qquad I_{ds} = \frac{W}{2L} K'(V_{gs} - V_t)^2 (1 + \lambda V_{ds})$$

where:

$I_{ds}$    is the drain to source current;
$W$    is the channel width;
$L$    is the channel length;
$K'$    is a constant equal to $(Cox)(\mu)$, where Cox is the effect of oxide capacitance and $\mu$ is the carrier mobility.
$\lambda$    is $1/V_a$, where $V_a$ is the so-called Early Voltage for a MOSFET.

then it can be seen that the so-called back gate transconductance, $g_{mb}$, is given by Equation 3.

$$\text{Equation 3} \qquad g_{mb} = \frac{\partial I_{ds}}{\partial V_{bs}} = \frac{\partial I_{ds}}{\partial V_t} \star \frac{\partial V_t}{\partial V_{bs}} = \frac{W}{L} K'(V_{gs} - V_t)(1 + \lambda V_{ds})\frac{\gamma}{2\sqrt{V_{sb} + 2\varnothing_F}}$$

Where, $V_{ds}$ is the drain-to-source voltage, $V_{gs}$ is the gate-to-source voltage, $V_{bs}$ is the body-to-source voltage, $I_{ds}$ is the drain-to-source current.

Therefore, if the threshold voltage can be made relatively independent of $V_{sb}$, then $g_{mb}$ will tend towards zero. Hence, the gain (Av) of the source follower, (as given by the expression shown in Equation 4 below), goes up and becomes independent of $V_{sb}$, and as a result, becomes more linear, i.e., is more constant.

$$\text{Equation 4} \qquad A_v = \frac{1}{1 + \dfrac{g_{mb} + g_{dsD} + g_{dsL}}{g_m}}$$

Here, $g_{dsD}$ and $g_{dsL}$ are the respective drain-to-source conductance of the driver and load FETs in the source follower circuit (defined by $g_{ds} = d(I_{ds})/d(v_{ds})$), $\lambda$ is $1/V_a$ where $V_a$ is the so-called Early voltage, the threshold voltage parameter, $\gamma$, is given by Equation 5 below.

$$\text{Equation 5} \qquad \gamma = \sqrt{\frac{2q\varepsilon_s N_A}{Cox'}}$$

with $N_A$ being the FET's background concentration, q is the charge of an electron, and $\varepsilon_s$ is the permitivity of silicon.

The top-gate transconductance, $g_m$, (defined in a similar manner to the back-gate transconductance) which can be shown to be given by the expression illustrated in Equation 6.

$$\text{Equation 6} \qquad g_m = \frac{\partial\, I_{ds}}{\partial\, V_{gs}} = \frac{W}{L} K'(V_{gs} - V_t)(1 + \lambda V_{ds})$$

From Equations 3, 4 and 5, it can be seen that increasing the well concentration $N_A$, increases $\gamma$, and hence $g_{mb}$, thereby resulting in the reduction of the gain of the source follower, $A_v$. The converse is also evident. Additionally, from Equation 3 and 4, it can be seen that the gain changes with the input (and output) voltage since $v_{sb}=v_{out}$ for this source follower combination. Therefore, this results in a nonlinear behavior.

This invention relates to the elimination of the body effect through reduction of the well concentration under the source-follower drive FETs (i.e., the concentration of the body of the drive transistors) to the point where it (the well) becomes fully depleted. Under this condition, the threshold voltage becomes virtually independent of "back bias", Vsb. This then results in an amplifier with highly linear gain characteristics as discussed above.

These and other aspects, objects, features and advantages of the present invention will be more clearly understood and appreciated from a review of the following detailed description of the preferred embodiments and appended claims, and by reference to the accompanying drawings.

## Advantageous Effect Of The Invention

The present invention provides a process to fabricate transistors whose threshold voltages are virtually independent of back bias. These transistors can be used in source-follower configurations on a typical image sensor with greatly improved gain characteristics and linearity. This method of eliminating the body effect eliminates the problems and/or operational limitations that might be encountered by other techniques typically employed in a standard CMOS technology, (i.e., placing the transistors in isolated wells and electrically connecting their source and body nodes).

## BRIEF DESCRIPTION OF THE DRAWINGS

Fig. 1 is a schematic of a typical source-follower configuration used in output structures on most present day CCD image sensors;

Fig. 2 is a cross section from the source to the drain of the transistor QD shown in Fig. 1;

Fig. 3 shows the electrostatic simulation for various well doping concentrations (doses);

Fig. 4 shows the threshold voltage as a function of the square root of back bias voltage;

Figs. 5a-5d show the gain (Av) versus the input voltage (Vin) for a three-stage source follower where each stage is as shown in Fig. 1 for various well doping concentrations;

Fig. 6a and Fig. 6b show the channel potential versus the gate voltage for the drive transistors of Figs. 5a and 5b, respectively.

To facilitate understanding, identical reference numerals have been used, where possible, to designate identical elements that are common to the figures.

## DETAILED DESCRIPTION OF THE INVENTION

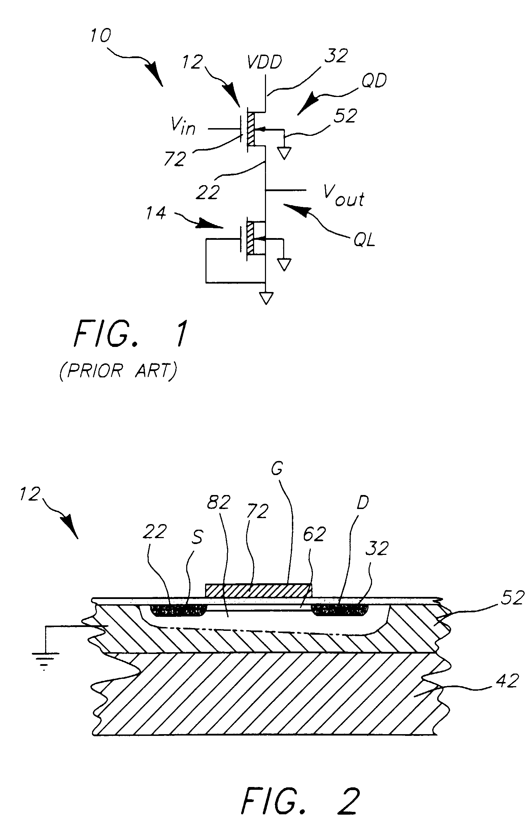

Shown in Fig. 1 is a schematic of a typical source-follower 10 configuration used in the output structure on most present day, CCD image sensors. The circuit has a drive transistor 12, labeled QD, and a load transistor 14, labeled QL, which provides a constant current bias for the source 22 of the drive transistor 12. Typically, two or three of these source-follower "stages" are cascaded to form the overall output amplifier. It is envisioned that each stage would be constructed in a similar fashion in accordance with the teachings of the present invention, as described in greater detail hereinbelow. The present invention improves upon the prior art by having the drive transistor 12 created with reduced doping levels in the p-type material below the drive transistor 12. This results in a source-follower 10 that has greater linearity than prior art devices. It should be understood that the specific conductivity types used for the various parts of source-follower 10 described herein, represent the embodiment most preferred by the inventor. Configurations employing different conductivity types are also envisioned. It should also be noted, that other load configurations may be possible without detracting from the scope of the invention.

Fig. 2 shows a cross-section of the driver transistor 12 of Fig. 1 taken from source 22 to the drain 32 of drive transistor 12. As illustrated in Fig. 2, the driver transistor 12 has an n+ type substrate with a p-type well 52 formed, therein. Both the source 22 and the drain 32 are formed of n+ type material, with an n-type buried channel 62 formed between them. An essential ingredient of the present invention is the lightly doped area 82 within p-type well 52 beneath at least the drive transistor 12 of source follower 10. The effect of lightly doped area 82 will be discussed in further detail below. Although an n-type, buried channel FET in a p-well within an n-type substrate is shown, variations of this would be possible as would be obvious to one skilled in the art. For example, surface channel FETs could be used, and/or opposite conductivity types could be used. The preferred embodiment of the present invention actually employs a p-well 52 that is lightly doped beneath both load transistor 14 and the drive transistor 12, however, it is also envisioned that embodiments employing a lightly doped p-well beneath only the drive transistor 12 would be equally useful for the purposes of the present invention.

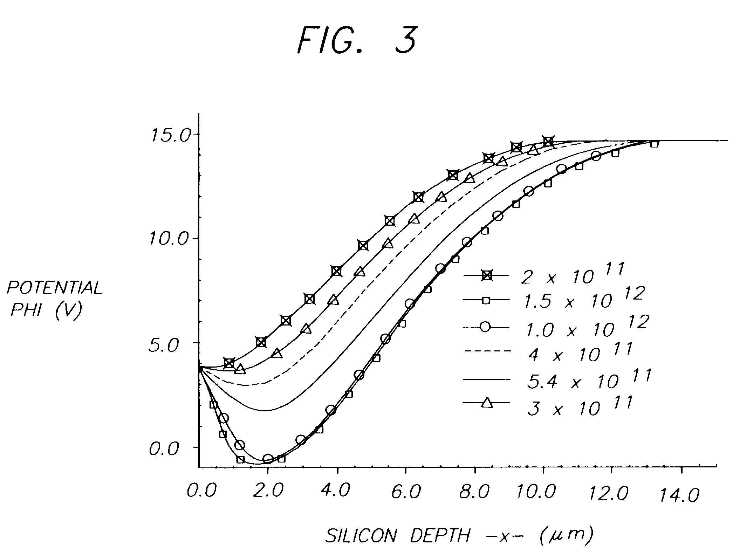

Fig. 3 shows the electrostatic simulation of the 1-D potential profiles into the silicon at the source node 22 of the drive transistor 12 for various p-well 52 doping levels. Note that when the p-well dose has an impurity level that reaches $1.0*10^{12}/cm^2$, that the p-well 52 becomes completely depleted (as indicated by the lack of any quasi-neutral region). Also note that when the p-well 52 dose becomes too small, that the potential barrier from the source to the substrate, $\phi_B$, is so small that current flow will result. This is the condition known as punchthrough, and is undesirable. Therefore, for a given process, there is a range of well doping for which the p-well 52 will be fully depleted while avoiding punchthrough. Generally, it is best to use the higher end of this range to reduce short channel effects which also serve to reduce the gain of the source follower configuration by the term $g_{dsD}$. Although the process used here actually has two p-well implants (which result naturally as part of this particular process), this is not a requirement of the invention. This invention could just as easily be practiced in a process wherein only a single implant is used to form the p-well underneath these transistors as would be well understood by those skilled in the art. It is also to be understood that other variations are entirely possible such as using surface channel transistors (as opposed to buried-channel devices as shown here), reversing conductivity types of the various layers to provide p-channel FETs, or other such modifications without departing from the scope of the invention;

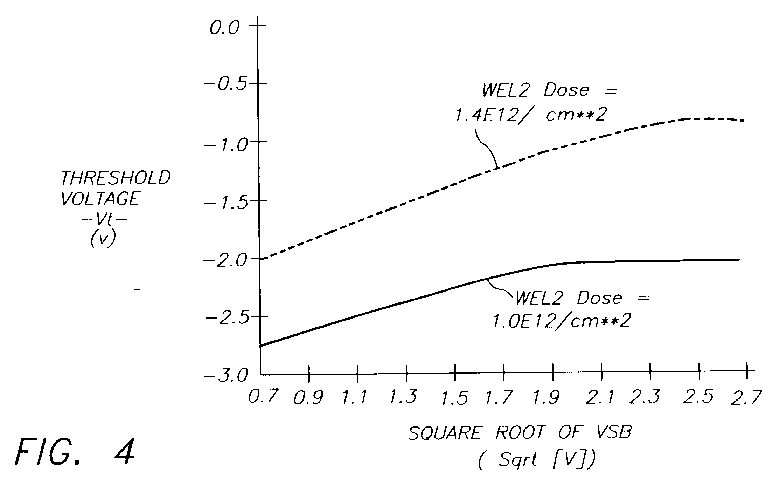

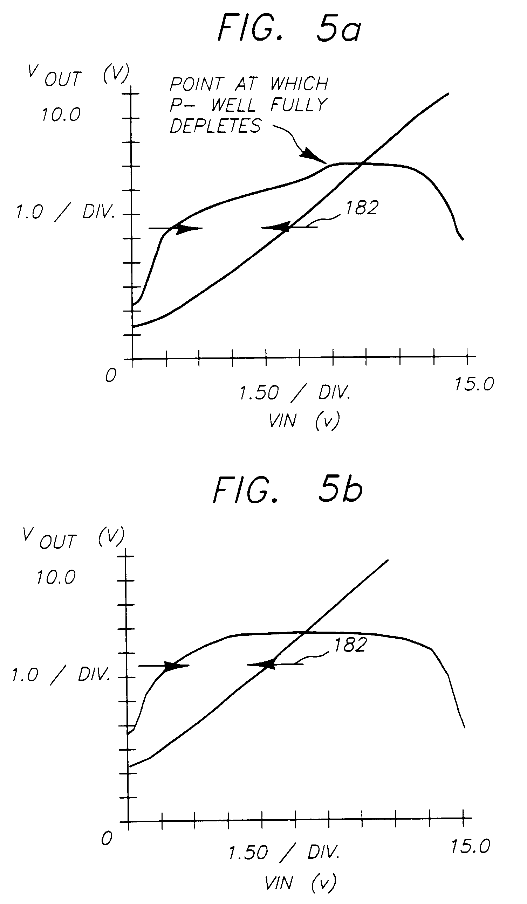

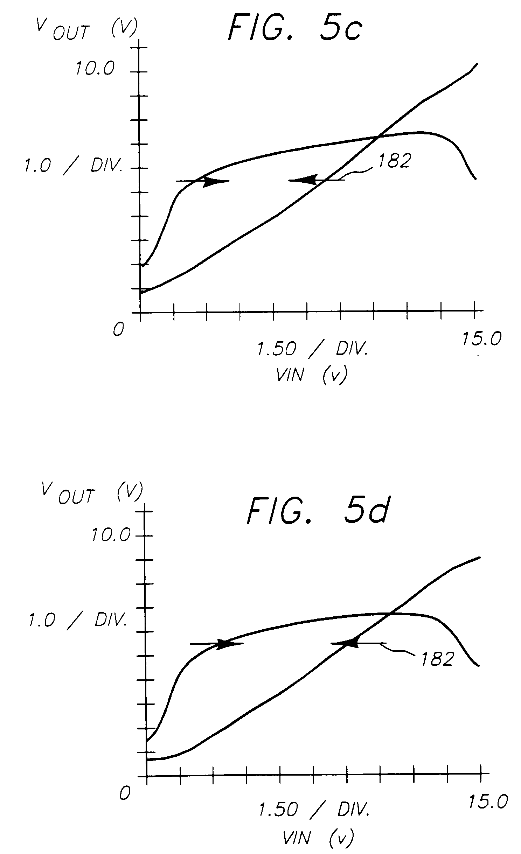

Fig. 4 shows the threshold voltage as a function of the square root of the back bias voltage, $V_{sb}$. As the p-well continues to deplete as $V_{sb}$ increases, note that eventually $V_t$ saturates. This is the point where the p-well becomes fully depleted, and hence, $V_t$ becomes relatively independent of $V_{sb}$. The effect of doping concentration on the point at where full depletion occurs can also be seen from this plot. Note that for the higher p-well dose, that the source voltage ($V_{sb}$) required to reach this fully depleted condition increases. Hence, the source follower using a drive transistor with a higher p-well dose would have poorer gain and a more limited linear range, i.e., a smaller range of $V_{in}$ or $V_{out}$ wherein the gain is constant. This can be seen in Figs. 5a and 5b which show the gain (Av) versus input voltage ($V_{in}$) for three-stage source followers using the same types of transistors used in Fig. 4. Figs. 5c and 5d show these same gain curves for even higher p-well doses. Note for impurity dosage levels of $1.7*10^{12}$, that the gain does not become constant until just before the drive transistor goes out of saturation so that amplifier is mostly nonlinear except within an extremely small range up near the high-end gain "roll off point". For dosage levels of $2.0*10^{12}$, the gain is seen to be nowhere a constant value, i.e., this amplifier has no linear operating range.

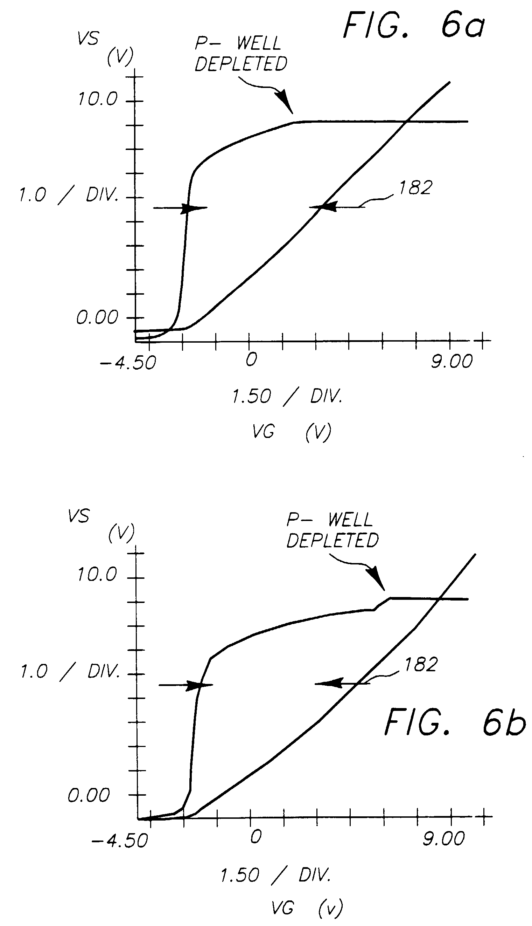

Another way of looking at this point at where full depletion occurs is from the so-called channel potential curves for the transistors. Figs. 6a and 6b show the channel potential (here, given as $V_s$) versus gate voltage ($V_g$) for the same two transistors used in Fig. 4. Here, the point at where the p-well becomes fully depleted is indicated by the point at which the slope of the $V_s$ vs $V_g$ curve becomes constant. As before, it can be seen that the higher p-well does requires a higher value of $V_g$ (and $V_s$) to fully deplete the p-well and hence, results in a smaller range over which the source follower will have a constant gain.

The invention has been described with reference to a preferred embodiment. However, it will be appreciated that variations and modifications can be effected by a person of ordinary skill in the art without departing from the scope of the invention.

## Parts List:

10    source follower circuit
12    driver transistor (QD)
14    load transistor (QL)
22    source node of QD
32    drain node of QD
42    n-type substrate
52    p-type well
62    n-type buried channel
72    gate electrode
82    lightly doped area beneath drive transistor

## Claims

1.    An output amplifier comprising:

a semiconductor substrate of a first conductivity type having formed thereon a well of a second conductivity type that is opposite the first conductivity type;

a source-follower circuit having a MOS driver transistor and a MOS load transistor formed within the well, each of the driver transistor and the load transistors having a source node and a drain node formed of the first conductivity type;

a channel region between the source node and drain node for the driver transistor and the load transistor;

a gate electrode structure on top the channel region and between the source node and the drain node for each the driver transistor and the load transistor; and

a portion of the well at least beneath the driver transistor that is lightly doped of the second conductivity such that it is fully depleted during operation.

2. The output amplifier of claim 1 wherein the channel region is a buried channel.

3. The output amplifier of claim 1 wherein the channel region is a surface channel.

4. The output amplifier of claim 1 wherein the portion that is lightly doped has a doping level that is selected within an operating range of interest such that the lightly doped portion beneath the driver transistor is fully depleted but still retains a potential barrier between the channel region and the substrate.

5. The output amplifier of claim 4 wherein the first conductivity type is n-type, the second conductivity type is p-type, and the portion that is lightly doped has a p-type doping level that is essentially $1*10^{12}$ impurities/cm$^2$.

6. The output amplifier of claim 4 wherein the portion that is lightly doped has a doping level range that has a maximum doping level determined to be at essentially the level at which full well depletion occurs and a minimum doping determined by the point at which punch through occurs between the drive transistor's channel region and the substrate.

7. A process of fabricating transistors comprising the steps of:

providing a semiconductor substrate of a first conductivity having a well of a second conductivity opposite the first conductivity type formed in the substrate;

providing a transistor within the well, the transistor formed from creating a source, a drain and a channel between the source and the drain such that the source, and drain are all of first conductivity type, and further providing that the well has a doping level beneath the transistor in a range such that the well becomes fully depleted and yet still provides a potential barrier between the channel and substrate regions; and

providing a gate electrode structure between the source and the drain, and above the channel region.

8. The process of claim 7 wherein the channel is a buried channel of the first conductivity type.

9. The process of claim 7 wherein the channel is a surface channel of the second conductivity type.

10. The process of claim 7 wherein the process is employed for fabricating output amplifiers and wherein the step of providing a transistor further comprises providing a source follower configuration having a drive transistor and a load transistor with a well beneath both transistors having the doping level the range at least beneath the drive transistor.

FIG. 1

(PRIOR ART)

FIG. 2

## FIG. 3

POTENTIAL
PHI (V)

SILICON DEPTH −x− (μm)

Legend:
- 2 x 10^11
- 1.5 x 10^12
- 1.0 x 10^12
- 4 x 10^11
- 5.4 x 10^11
- 3 x 10^11

FIG. 4

# FIG. 5a

V OUT (V)

10.0

POINT AT WHICH
P- WELL FULLY
DEPLETES

1.0 / DIV.

182

0

1.50 / DIV.

15.0

VIN (v)

# FIG. 5b

V OUT (V)

10.0

1.0 / DIV.

182

0

1.50 / DIV.

15.0

VIN (v)

FIG. 5c

FIG. 5d

FIG. 6a

VS (V)

P— WELL DEPLETED

10.0

1.0 / DIV.

182

0.00

-4.50          0          9.00

1.50 / DIV.

VG   (V)

VS (V)

P— WELL DEPLETED

10.0

1.0 / DIV.

182

FIG. 6b

0.00

-4.50          0          9.00

1.50 / DIV.

VG  (v)